(19) Europäisches Patentamt / European Patent Office / Office européen des brevets

(11) **EP 3 413 062 B1**

(12) **EUROPÄISCHE PATENTSCHRIFT**

(45) Veröffentlichungstag und Bekanntmachung des Hinweises auf die Patenterteilung:
**27.07.2022   Patentblatt 2022/30**

(21) Anmeldenummer: **18173770.1**

(22) Anmeldetag: **23.05.2018**

(51) Internationale Patentklassifikation (IPC):
**G01R 27/18** *(2006.01)*      **G01R 31/08** *(2020.01)*
**G01R 31/52** *(2020.01)*

(52) Gemeinsame Patentklassifikation (CPC):
**G01R 31/52; G01R 27/18; G01R 31/08**

(54) **VERFAHREN UND VORRICHTUNG ZUR ISOLATIONSFEHLERSUCHE IN EINEM UNGEERDETEN STROMVERSORGUNGSSYSTEM MIT ADAPTIVER PRÜFSTROMDAUER**

METHOD AND DEVICE FOR ISOLATION ERROR SEARCH IN UNGROUNDED POWER SUPPLY SYSTEMS WITH ADAPTIVE TEST CURRENT DURATION

PROCÉDÉ ET DISPOSITIF DE LOCATION DE DÉFAUTS D'ISOLEMENT POUR UN SYSTÈME D'ALIMENTATION ÉLECTRIQUE NON MIS À LA TERRE AVEC UNE DURÉE ADAPTATIVE D'UN COURANT DE TEST.

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **08.06.2017   DE 102017209663**

(43) Veröffentlichungstag der Anmeldung:
**12.12.2018   Patentblatt 2018/50**

(73) Patentinhaber: **Bender GmbH & Co. KG**
**35305 Grünberg (DE)**

(72) Erfinder:
• **SCHÄFER, Oliver**
**35305 Grünberg (DE)**

• **BECKER, Helmut**
**35305 Grünberg (DE)**
• **HARTMANN, Carsten**
**63679 Schotten (DE)**

(74) Vertreter: **advotec.**
**Patent- und Rechtsanwaltspartnerschaft Tappe mbB**
**Georg-Schlosser-Straße 6**
**35390 Gießen (DE)**

(56) Entgegenhaltungen:
**EP-A1- 0 654 673          EP-A1- 1 593 983**
**EP-A1- 3 109 647          EP-A1- 3 139 188**
**DE-A1-102015 102 310      DE-C1- 10 106 200**

**Beschreibung**

Die Erfindung betrifft ein Verfahren zur Isolationsfehlersuche sowie eine Isolationsfehlersucheinrichtung für ein ungeerdetes Stromversorgungssystem.

Bei erhöhten Anforderungen an die Betriebs-, Brand und Berührungssicherheit kommt die Netzform eines ungeerdeten Stromversorgungssystems zum Einsatz, die auch als isoliertes Netz (frz. Isolé Terre - IT) oder als IT-Stromversorgungssystem bezeichnet wird. Bei dieser Art des Stromversorgungssystems sind die aktiven Teile von dem Erdpotenzial - gegenüber "Erde" - getrennt. Der Vorteil dieser Netze liegt darin, dass bei einem Isolationsfehler (erster Fehler), wie beispielsweise einem Erdschluss oder einem Körperschluss, die Funktion der angeschlossenen elektrischen Verbraucher nicht beeinträchtigt wird, da sich wegen des im Idealfall - Netzableitkapazitäten seien dabei vernachlässigt - unendlich großen Impedanzwertes zwischen einem aktiven Leiter des Netzes und Erde kein geschlossener Stromkreis ausbilden kann.

Durch diese inhärente Sicherheit des ungeerdeten Stromversorgungssystems kann somit eine kontinuierliche Stromversorgung der von dem ungeerdeten Stromversorgungssystem gespeisten Verbraucher auch dann gewährleistet werden, wenn ein erster Isolationsfehler auftritt.

Der Widerstand des ungeerdeten Stromversorgungssystems gegen Erde (Isolationswiderstand - im Fehlerfall auch Isolationsfehlerwiderstand oder Fehlerwiderstand) wird daher ständig überwacht, da durch einen möglichen weiteren Fehler an einem anderen aktiven Leiter (zweiter Fehler) eine Fehlerschleife entstünde und der dabei fließende Fehlerstrom in Verbindung mit einer Überstrom-Schutzeinrichtung eine Abschaltung der Anlage mit Betriebsstillstand zur Folge hätte.

Unter der Voraussetzung, dass der Isolationszustand des ungeerdeten Stromversorgungssystems kontinuierlich von einem Isolationsüberwachungsgerät überwacht wird, kann das ungeerdete Stromversorgungssystem auch bei einem aufgetretenen ersten Fehler ohne vorgeschriebene Zeitlimitierung weiterbetrieben werden, jedoch gilt die Empfehlung, den ersten Fehler so schnell wie praktisch möglich zu beseitigen.

Um die Anforderung nach der schnellen Beseitigung des ersten Fehlers zu erfüllen, stellt insbesondere in ausgedehnten, weit verzweigten ungeerdeten Stromversorgungssystemen oder in ungeerdeten Stromversorgungssystemen, in denen eine Abschaltung der Energieversorgung sicherheitskritisch sein kann, der Einsatz einer Isolationsfehlersucheinrichtung den Stand der Technik dar.

Die Isolationsfehlersucheinrichtung umfasst im Wesentlichen einen Prüfstromgenerator und mehrere meist als Messstromwandler ausgeführte Prüfstromsensoren, die zur Auswertung der Messsignale mit einem Isolationsfehlersuchgerät (Isolationsfehlerauswertegerät) verbunden sind.

Ist in dem ungeerdeten Stromversorgungssystem ein erster Isolationsfehler von dem Isolationsüberwachungsgerät erkannt worden, startet die Isolationsfehlersuche, indem der Prüfstromgenerator einen Prüfstrom erzeugt und diesen an zentraler Stelle in das ungeerdete Stromversorgungssystem zwischen einem oder mehreren aktiven Leitern und Erde einspeist (eingespeister Prüfstrom). Es entsteht ein geschlossener Stromkreis, in dem der Prüfstrom von dem Prüfstromgenerator über die spannungsführenden aktiven Leiter, den Isolationsfehler und über eine Erdverbindung zurück zu dem Prüfstromgenerator fließt.

Die Lokalisierung des Fehlerortes erfolgt über eine Detektion des Prüfstroms in dem ungeerdeten Stromversorgungssystem durch das Isolationsfehlersuchgerät mit den daran angeschlossenen Messstromwandlern, wobei jedem zu überwachenden Leitungsabschnitt ein Messstromwandler fest zugeordnet ist. Der so detektierte Prüfstrom entspricht einem in dem zu überwachenden Leitungsabschnitt erfassbaren Prüfstrom, wobei ein vernachlässigbarer, stationärer Prüfstromanteil über die ohmschen Anteile der Ableitimpedanzen außerhalb des Fehlerstromkreises fließt.

Der jeweilige erfassbare Prüfstrom wird dabei von allen Messstromwandlern, die in dem Prüfstromkreis (Fehlerstromkreis) liegen, als Differenzstrom erfasst und in dem Isolationsfehlersuchgerät ausgewertet und angezeigt. Durch die bekannte Zuordnung der Messstromwandler zu den Leitungszweigen kann der Fehlerort lokalisiert werden.

Allerdings stößt die Erfassung des Prüfstroms an ihre Grenzen, weil insbesondere in weit verzweigten ungeerdeten Stromversorgungssystemen die Netzableitkapazitäten nicht vernachlässigbare Werte annehmen und demzufolge den Prüfstrom störende (Ableit-)Differenzströme entstehen können.

Ein weiterer Nachteil bei den bislang angewendeten Verfahren zur Isolationsfehlersuche besteht darin, dass der Prüfstrom im Hinblick auf den Personen- und Anlagenschutz auf einen maximalen Wert begrenzt ist. Beispielsweise werden für Prüfströme in Verbindung mit empfindlichen Anlagenteilen obere Grenzwerte im Bereich von maximal 1 mA bis 2.5 mA gefordert - selbst bei großen Netzableitkapazitäten von 10 $\mu$F bis 1000 $\mu$F.

Gerade in Verbindung mit hochohmigen Isolationsfehlern und daraus folgenden geringen Stromstärken im Fehlerstromkreis sind daher eine sichere Erfassung und Auswertung des Prüfstroms und damit eine zuverlässige Lokalisierung des Fehlerortes nicht immer gewährleistet.

Diesen Problemen wird gegenwärtig nur durch eine unerlaubte Überschreitung des maximal zulässigen Prüfstroms oder durch eine sukzessive, zeit- und kostenaufwändige Abschaltung von Anlagenteilen begegnet.

Das Dokument EP 3 139 188 A1 zeigt ein Verfahren und eine Vorrichtung zur Isolationsfehlersuche mittels adaptiver Prüfstromermittlung. Dabei wird als Prüfstromparameter die Prüfstromamplitude und/oder die Prüfstrompulsdauer in Abhängigkeit eines elektrischen Systemparameters so angepasst, dass eine Messung des erfassten Prüfstromanteils im eingeschwungenen Zustand erfolgen kann.

Das Dokument EP 1 593 983 A1 offenbart ein Verfahren und eine Einrichtung zur Isolationsfehlerortung in einem isolierten ungeerdeten Wechselstromnetz, wobei zunächst eine Erfassung der Netzstörungen und deren Auswertung mittels Stromzeitflächenberechnung und daraus abgeleitet Prüfimpulse mit einer optimalen Prüfimpulszeit und -pausenzeit gebildet werden.

Der vorliegenden Erfindung liegt somit die Aufgabe zu Grunde, ein Verfahren und eine Vorrichtung zur Isolationsfehlersuche in einem ungeerdeten Stromversorgungssystem vorzuschlagen, die insbesondere bei Auftreten von hochohmigen Isolationsfehlern in Verbindung mit großen Netzableitkapazitäten eine hinsichtlich des Zeit- und Kostenaufwands effiziente und technisch zuverlässige Lokalisierung des Isolationsfehlers unter Wahrung des Personen- und Anlagenschutzes ermöglichen.

Diese Aufgabe wird gelöst durch ein Verfahren gemäß Anspruch 1.

Der Grundgedanke der vorliegenden Erfindung beruht darauf, unter Einhaltung einer vorgegebenen, maximal zulässigen Prüfstromamplitude die Prüfstrom-Impulsdauer bzw. die Prüfstrom-Pausendauer des Prüfstroms so einzustellen, dass sämtliche Störgrößen in dem erfassten Differenzstrom, insbesondere die infolge großer Netzableitkapazitäten auftretenden Ableitströme, eliminiert werden. Der Prüfstrom kann somit in vorteilhafter Weise auch unter ungünstigen anlagentechnischen Bedingungen in einem weit verzweigten ungeerdeten Stromversorgungssystem erfasst werden.

Dazu wird zunächst mittels eines Prüfstromgenerators ein Prüfstrom mit periodischem Verlauf erzeugt und in das ungeerdete Stromversorgungssystem zwischen einem oder mehreren aktiven Leitern und Erde eingespeist. Eine Prüfstromperiode des periodischen Prüfstroms setzt sich aus zeitlich aufeinanderfolgenden Prüfstromimpulsen und dazwischenliegenden Prüfstrompausen (Nulllinien) zusammen.

Die Prüfstrom-Impulsdauer bzw. die Prüfstrom-Pausendauer wird während der Ausführung des Verfahrens in Abhängigkeit des erfassten und ausgewerteten Differenzstroms adaptiv eingestellt (siehe folgende Verfahrensschritte), wohingegen die Amplitude der Prüfstromimpulse auf einen durch die Art und Beschaffenheit der elektrischen Anlage vorgegebenen maximalen Wert (maximale Prüfstromamplitude) begrenzt ist.

Die Begrenzung der Prüfstromamplitude trägt dem Personen- und Anlagenschutz Rechnung und schließt somit Sicherheitsrisiken während der Fehlersuche weitgehend aus.

Die Verfolgung des in dem Fehlerstromkreis fließenden Prüfstroms geschieht durch die Erfassung von Differenzströmen mit verteilt an den zu überwachenden Leitungsabschnitten angeordneten Messstromwandlern, welche zur Auswertung der erfassten Differenzströme mit einem Isolationsfehlersuchgerät verbunden sind.

Sofern der zu überwachende Leitungsabschnitt in dem Fehlerstromkreis liegt, ist ein signifikanter Teil des eingespeisten Prüfstroms als Differenzstrom in diesem Leitungsabschnitt erfassbar (erfassbarer Prüfstrom). In der Regel setzt sich der erfasste Differenzstrom aus dem erfassbaren Prüfstrom und dynamischen, abklingenden Störanteilen (kapazitive Netzableitströme) sowie weiteren anlagenbedingten, statischen (absoluten) Störströmen zusammen. Um die dynamischen, abklingenden Störkomponenten innerhalb des erfassten Differenzstroms zu eliminieren, erfolgt eine Bestimmung eines Endwertes des Differenzstroms. Als Endwert wird hier ein stationärer Wert des Differenzstroms bezeichnet, der sich sowohl nach einem Einschwingvorgang als Reaktion auf das Einschalten eines Prüfstromimpulses, als auch nach einem Abklingen als Reaktion auf ein Ausschalten des Prüfstromimpulses einstellt.

Nachdem die Umladevorgänge der Netzableitkapazitäten abgeklungen sind, stellt sich - bei hinreichend lange andauerndem Prüfstromimpuls bzw. andauernder Prüfstrompause - ein stationärer Zustand des erfassten Differenzstroms ein. Sobald dieser stationäre Zustand an der Messstelle festgestellt wird, beispielsweise durch Auswertung der Schwankungsbreite der erfassten Differenzstromamplitude oder durch Auswertung der zeitlichen Änderung des Differenzstrom-Amplitudenverlaufs, werden der Endwert des Differenzstroms und die zugehörige Einschwingdauer bzw. Abklingdauer durch das Isolationsfehlersuchgerät bestimmt.

Zur Messung des Endwertes werden allstromsensitive Messstromwandler vom Typ B eingesetzt, die in der Lage sind, neben Wechsel-Differenzströmen und pulsierenden Gleich-Differenzströmen auch glatte Gleich-Differenzströme zu erfassen.

Ergibt eine Prüfung des Betrages des Endwertes des Differenzstroms eine Überschreitung eines Prüfstrom-Grenzwertes, gilt diese Überschreitung als Indikator dafür, dass in dem betreffenden Leitungsabschnitt ein Prüfstrom oder zumindest ein signifikanter Prüfstromanteil fließt und der betreffende Leitungsabschnitt somit in dem Fehlerstromkreis liegt.

Ein durch Ableitströme bedingter, abklingender Differenzstrom wird durch die Bestimmung des Endwertes eliminiert, wobei insbesondere die negativen Auswirkungen von sehr großen Netzableitkapazitäten im Bereich von 10 $\mu$F bis 1000 $\mu$F ausgeschaltet und Fehlmessungen auf diese Weise vermieden werden können.

Wurde in dem zu überwachenden Leitungsabschnitt mittels Differenzstrommessung durch Überschreitung des Prüfstrom-Grenzwertes der erfassbare Prüfstrom ermittelt, erfolgt über eine Kommunikationsverbindung eine Übermittlung des Wertes der Einschwingdauer bzw. der Abklingdauer von dem Isolationsfehlersuchgerät an den Prüfstromgenerator.

Daraufhin wird die Prüfstrom-Impulsdauer bzw. die Prüfstrom-Pausendauer durch den Prüfstromgenerator in Abhängigkeit der übermittelten Einschwingdauer bzw. der Abklingdauer so eingestellt, dass der Differenzstrom seinen Endwert innerhalb der Prüfstrom-Impulsdauer bzw. der Prüfstrom-Pausendauer erreicht.

Die vorgegebene maximale Prüfstromamplitude bleibt dabei unverändert. Die in dem Prüfstromgenerator erzeugte Prüfstrom-Periodendauer wird somit an die in dem Isolationsfehlersuchgerät bestimmte Einschwingdauer angepasst. Gleichzeitig werden maximal zulässige Prüfstromamplituden im Bereich von 1 mA bis 2.5 mA eingehalten.

Die adaptive Einstellung der Prüfstrom-Impulsdauer bzw. der Prüfstrom-Pausendauer in Abhängigkeit der ermittelten Einschwingdauer gewährleistet eine hinsichtlich des Zeit- und Kostenaufwands effiziente und technisch zuverlässige Lokalisierung des Isolationsfehlers bei gleichzeitiger Einhaltung der Sicherheitsbestimmungen.

Erfindungsgemäß werden weiter die folgenden Verfahrensschritte ausgeführt: bei abgeklungenem Prüfstromimpuls wird ein erster Differenzstrom-Basiswert bestimmt, nach Einspeisen des Prüfstromimpulses wird bei eingeschwungenem Prüfstromimpuls ein Einschwing-Differenzbetrag zwischen dem Differenzstrom-Endwert und dem ersten Differenzstrom-Basiswert gebildet, nach Abklingen des Prüfstromimpulses wird ein zweiter Differenzstrom-Basiswert bestimmt, ein Abkling-Differenzbetrag wird zwischen dem Differenzstrom-Endwert und dem zweiten Differenzstrom-Basiswert gebildet. Falls der Einschwing-Differenzbetrag innerhalb eines Toleranzbereichs mit dem Abkling-Differenzbetrag übereinstimmt, liegt eine gültige Erfassung des Differenzstroms vor, um den erfassbaren Prüfstrom zu erkennen.

Zwar werden durch die Betrachtung des Endwertes des Differenzstroms die dynamischen, abklingenden Störströme beseitigt, die anlagenbedingten, statischen Störströme aber werden auch in dem eingeschwungenen Zustand des Prüfstroms erfasst und können zu Fehlaussagen hinsichtlich der Erkennung eines erfassbaren Prüfstroms führen.

Daher wird zunächst am Ende einer Prüfstrompause bei abgeklungenem Prüfstromimpuls ein erster Differenzstrom-Basiswert bestimmt. Zwischen diesem ersten Differenzstrom-Basiswert und dem in eingeschwungenem Zustand bestimmten Differenzstrom-Endwert wird ein Einschwing-Differenzbetrag gebildet, der einem von dem eingespeisten Prüfstromimpuls verursachten Differenzstromanteil entsprechen sollte. Zur Überprüfung, ob der erfassbare Prüfstrom innerhalb des erfassten Differenzstroms fehlerfrei erkannt wird, werden nach Abklingen des Prüfstromimpulses ein zweiter Differenzstrom-Basiswert bestimmt und ein Abkling-Differenzbetrag zwischen dem Differenzstrom-Endwert und dem zweiten Differenzstrom-Basiswert gebildet. Unter der Voraussetzung, dass ein vorhandener statischer Störstrom konstant ist, sollten der Einschwing-Differenzbetrag und der Abkling-Differenzbetrag unter Berücksichtigung eines festgelegten Toleranzbereiches (Wertebereich-Fenster) gleich sein. In diesem Fall entspricht der Einschwing-Differenzbetrag bzw. der Abkling-Differenzbetrag einem von dem eingespeisten Prüfstromimpuls verursachten Differenzstromanteil und damit dem erfassbaren Prüfstrom. Ein vorhandener statischer Störstrom ist auf diese Weise rechnerisch eliminiert worden.

In weiterer vorteilhafter Ausgestaltung wird ein Teilisolationswiderstand des zu überwachenden Leitungsabschnitts aus einem von einem Isolationsüberwachungsgerät ermittelten Gesamtisolationswiderstand des ungeerdeten Stromversorgungssystems, aus dem eingespeisten Prüfstrom und aus dem Endwert des Differenzstroms bestimmt.

Da vor dem Start der Isolationsfehlersuche stets der Gesamtisolationswiderstand Riso des ungeerdeten Stromversorgungssystems durch das Isolationsüberwachungsgerät überwacht und ermittelt wurde, kann dieser Gesamtisolationswiderstand Riso zur Berechnung des Teilisolationswiderstands Rx des zu überwachenden Leitungsabschnitts herangezogen werden. Gemäß dem ohmschen Gesetz und den in linearen Netzen geltenden Strom-Spannungsbeziehungen kann aus dem Verhältnis des eingespeisten Prüfstroms IL zu dem als Endwert Ix des Differenzstroms erfassbaren Prüfstrom der Teilisolationswiderstand Rx des zu überwachenden Leitungsabschnitts berechnet werden:

$$Rx = Riso\ (IL\ /\ Ix).$$

Bevorzugt wird die Prüfstromperiode zeitlich unmittelbar aufeinanderfolgend aus einem positiven Prüfstromimpuls, einer positiven Prüfstrompause, einem negativen Prüfstromimpuls und einer negativen Prüfstrompause gebildet.

Ein derartiger Verlauf des Prüfstroms ist in einfacher Weise sowohl mit einer aktiven Spannungs- oder Stromquelle, als auch in passiver Form, getrieben durch die Netzspannung, zu generieren.

Das Erzeugen des Prüfstroms in dem Prüfstromgenerator kann also aktiv durch eine unabhängige Spannungs- oder Stromquelle innerhalb des Prüfstromgenerators erfolgen.

Der Prüfstromgenerator ist hierbei als eigenständiges aktives Gerät oder als aktive in das Isolationsüberwachungsgerät integrierte Funktionseinheit ausgeführt und umfasst eine unabhängige Spannungs- oder Stromquelle zur Erzeugung des Prüfstroms. Diese Ausgestaltung erlaubt eine Durchführung der Isolationsfehlersuche auch in abgeschalteten, ungeerdeten Stromversorgungssystemen.

Alternativ erfolgt das Erzeugen des Prüfstroms in dem Prüfstromgenerator passiv, wobei der Prüfstrom durch die Netzspannung zwischen einem aktiven Leiter des Stromversorgungssystem und Erde getrieben wird. Als eigenständiges aktives Gerät oder als passive in das Isolationsüberwachungsgerät integrierte Funktionseinheit wird durch wechselweises Verbinden der aktiven Leiter des Stromversorgungssystems mit Erde eine impulsförmige, den Prüfstrom treibende Spannung erzeugt, wobei gleichzeitig die Prüfstromamplitude begrenzt wird.

Die der Erfindung zugrundeliegende Aufgabe wird weiterhin gelöst durch eine Isolationsfehlersucheinrichtung gemäß Anspruch 6.

In Umsetzung des erfindungsgemäßen Verfahrens zur Isolationsfehlersuche umfasst eine erfindungsgemäße Isolationsfehlersucheinrichtung als wesentliche Komponenten einen Prüfstromgenerator mit einer Prüfstrom-Einstelleinrichtung, ein Isolationsfehlersuchgerät mit einer Berechnungseinheit und mit einer Übermittlungseinrichtung sowie an das Isolationsfehlersuchgerät angeschlossene Messstromwandler.

Erfindungsgemäß ist die Berechnungseinheit weiterhin ausgelegt zur Bestimmung eines ersten Differenzstrom-Basiswertes, eines Einschwing-Differenzbetrags, eines zweiten Differenzstrom-Basiswertes, eines Abkling-Differenzbetrags und zur Prüfung, ob der Einschwing-Differenzbetrag innerhalb eines Toleranzbereichs mit dem Abkling-Differenzbetrag übereinstimmt.

Diese Ausführung der Berechnungseinheit ermöglicht im Sinne einer Plausibilitätsüberprüfung die zuverlässige Erkennung des erfassbaren Prüfstroms, indem der Einschwing-Differenzbetrag und der Abkling-Differenzbetrag im Rahmen eines festgelegten Toleranzbereichs auf Gleichheit geprüft werden. Wird aufgrund eines nicht konstanten, statischen Störstroms eine Ungleichheit festgestellt, so wird die Erkennung des erfassbaren Prüfstroms als unzuverlässig verworfen.

Als weitere vorteilhafte Ausgestaltung weist die Isolationsfehlersucheinrichtung eine Bestimmungseinrichtung zur Bestimmung eines Teilisolationswiderstands des zu überwachenden Leitungsabschnitts auf, wobei dieser Teilisolationswiderstand aus einem von einem Isolationsüberwachungsgerät bestimmten Gesamtisolationswiderstand des ungeerdeten Stromversorgungssystems, aus dem eingespeisten Prüfstrom und aus dem Endwert des Differenzstroms bestimmt wird.

Des weiteren ist die Prüfstrom-Einstelleinrichtung so ausgeführt, dass sich die Prüfstromperiode aus Prüfstromimpulsen und Prüfstrompausen zusammensetzt, wobei die Prüfstromperiode zeitlich unmittelbar aufeinanderfolgend aus einem positiven Prüfstromimpuls, einer positiven Prüfstrompause, einem negativen Prüfstromimpuls und einer negativen Prüfstrompause gebildet wird.

Der Prüfstromgenerator ist als aktives Gerät ausgeführt, welches den Prüfstrom durch eine unabhängige Spannungs- oder Stromquelle erzeugt oder der Prüfstromgenerator ist ein passives Gerät, wobei der Prüfstrom durch die Netzspannung zwischen einem aktiven Leiter des Stromversorgungssystem und Erde getrieben wird.

Dabei kann der Prüfstromgenerator als eigenständiges Gerät oder als eine in das Isolationsüberwachungsgerät integrierte Funktionseinheit ausgeführt sein.

Weitere vorteilhafte Ausgestaltungsmerkmale ergeben sich aus der nachfolgenden Beschreibung und den Zeichnungen, die eine bevorzugte Ausführungsform der Erfindung an Hand von Beispielen erläutern. Es zeigen:

> **Fig. 1:** ein ungeerdetes Stromversorgungssystem mit einer erfindungsgemäßen Isolationsfehlersucheinrichtung,

> **Fig. 2:** einen Verlauf eines periodischen eingespeisten Prüfstroms und

> **Fig. 3:** ein Ersatzschaltbild zur Ermittlung eines Teilisolationswiderstands eines zu überwachenden Leitungsabschnitts.

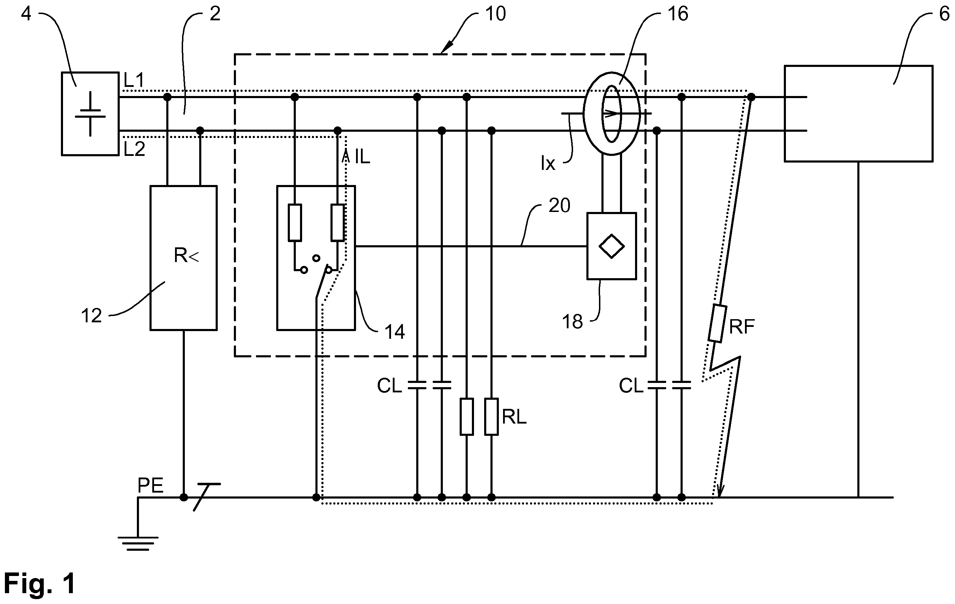

In **Fig. 1** ist in vereinfachter schematischer Darstellung ein ungeerdetes Stromversorgungssystem 2 mit einer erfindungsgemäßen Isolationsfehlersucheinrichtung 10 gezeigt. Das ungeerdete Stromversorgungssystem 2 besitzt zwei aktive Leiter L1, L2 und wird durch eine Gleichstromquelle 4 gespeist. Grundsätzlich können das erfindungsgemäße Verfahren zur Isolationsfehlersuche und die das Verfahren umsetzende Isolationsfehlersucheinrichtung 10 in beliebigen ein- oder mehrphasigen Gleich- oder Wechselstromnetzen eingesetzt werden.

An das ungeerdete Stromversorgungssystem 2 ist ein Verbraucher 6 angeschlossen, der über eine Erdverbindung PE mit Erdpotenzial (Erde) verbunden ist. Die aktiven Teile des ungeerdeten Stromversorgungssystems 2 weisen keine Erdverbindung auf, sodass sich bei einem ersten Fehler - in Fig. 1 dargestellt durch den Isolationsfehlerwiderstand RF - idealerweise, d.h. abgesehen von Ableitströmen über Netzableitimpedanzen RL, CL, kein geschlossener Fehlerstromkreis ausbilden kann.

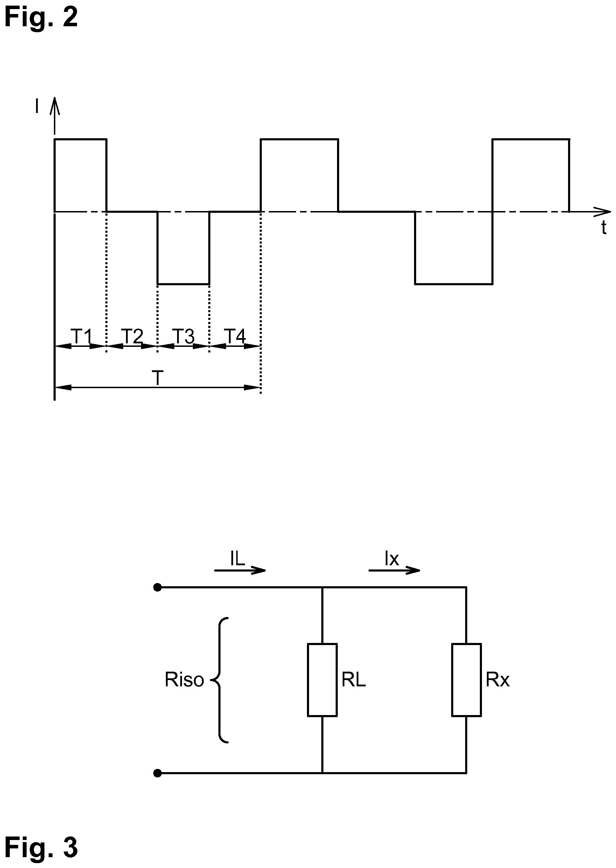

Ein Gesamtisolationswiderstand Riso (Fig. 3) des ungeerdeten Stromversorgungssystems 2 wird kontinuierlich mittels eines Isolationsüberwachungsgerätes 12 überwacht. Unterschreitet der ermittelte Gesamtisolationswiderstand Riso bei Auftreten des Isolationsfehlers (Isolationsfehlerwiderstand RF) einen Grenzwert, startet die Isolationsfehlersuche indem ein Prüfstromgenerator 14 einen Prüfstrom IL erzeugt und diesen nahe der versorgenden Stromquelle 4 zwischen den aktiven Leitern L1, L2 und Erde PE in das ungeerdete Stromversorgungssystem 2 einspeist (eingespeister Prüfstrom IL).

Der Prüfstromgenerator 14 ist passiv ausgeführt und erzeugt durch wechselweises Verbinden der aktiven Leiter L1, L2 des Stromversorgungssystems 2 mit Erde PE einen impulsförmigen, eingespeisten Prüfstrom IL (Fig. 2), der durch die wechselweise aufgeschaltete Netzspannung getrieben wird. Alternativ zu der Aufschaltung der Netzspannung als treibende Prüfstromquelle kann der Prüfstromgenerator 14 eine eigenständige, den eingespeisten Prüfstrom IL treibende Spannungs- oder Stromquelle enthalten.

Ein maßgeblicher Anteil des eingespeisten Prüfstroms IL fließt als erfassbarer Prüfstrom in einem geschlossenen Fehlerstromkreis über den Isolationsfehlerwiderstand RF und die Erdverbindung PE und kann als Differenzstrom in einem zu überwachenden Leitungsabschnitt von einem Messstromwandler 16 detektiert werden. Der Messstromwandler 16 ist zur Auswertung des Messergebnisses an ein Isolationsfehlersuchgerät 18 angeschlossen.

Nach dem Abklingen der Umladevorgänge in den inhärent vorhandenen Ableitkapazitäten - in Fig. 1 durch die konzentrierten Netzableitkapazitäten CL dargestellt - erreicht der Differenzstrom einen stationären Zustand. Die Einschwingdauer von Beginn des Prüfstromimpulses bis zum Erreichen eines stationären (eingeschwungenen) Zustands ebenso wie die Abklingdauer von Beginn der Prüfstrompause bis zum Erreichen eines stationären (abgeklungenen) Zustands und der stationäre Endwert Ix des Differenzstroms in dem jeweiligen stationären Zustand werden durch das Isolationsfehlersuchgerät 18 bestimmt. Falls der Betrag des Endwertes Ix einen Prüfstrom-Grenzwert überschreitet, kann davon ausgegangen werden, dass ein erfassbarer Prüfstrom über den zu überwachenden Leitungsabschnitt fließt und dieser Leitungsabschnitt in dem Fehlerstromkreis liegt.

Der jeweilige Wert der Einschwingdauer bzw. der Abklingdauer wird durch eine Übermittlungseinrichtung 20, die als Bussystem ausgeführt sein kann, an den Prüfstromgenerator 14 übertragen. Der Prüfstromgenerator 14 stellt daraufhin die Prüfstrom-Impulsdauer (T1, T3 in Fig. 2) bzw. die Prüfstrom-Pausendauer (T2, T4 in Fig. 2) so ein, dass der erfasste Differenzstrom seinen Endwert (Ix) innerhalb der Prüfstrom-Impulsdauer (T1, T3) bzw. innerhalb der Prüfstrom-Pausendauer (T2, T4) erreicht.

Das Isolationsfehlersuchgerät 18 gibt durch Bestimmung und Übermittlung der Einschwingdauer adaptiv die in dem Prüfstromgenerator 14 einzustellenden Werte der Prüfstrom-Impulsdauer (T1, T3) bzw. der Prüfstrom-Pausendauer (T2, T4) vor und bestimmt damit, zu welchem Zeitpunkt die Prüfstromimpulse an- und abgeschaltet werden.

Fig. 2 zeigt einen Verlauf eines periodischen eingespeisten Prüfstroms IL mit einer Prüfstromperiode, die zeitlich unmittelbar aufeinanderfolgend aus einem positiven Prüfstromimpuls, einer positiven Prüfstrompause, einem negativen Prüfstromimpuls und einer negativen Prüfstrompause gebildet wird.

Die Prüfstromperiode besitzt eine Prüfstrom-Periodendauer T, die sich aus den aufeinanderfolgenden Zeitabschnitten T1 (positive Prüfstrom-Impulsdauer), T2 (positive Prüfstrom- Pausendauer), T3 (negative Prüfstrom-Impulsdauer) und T4 (negative Prüfstrom-Pausendauer) zusammensetzt.

Aufgrund der adaptiven Einstellung kann sich die Prüfstrom-Impulsdauer (T1, T3) und die Prüfstrom-Pausendauer (T2, T4) ändern.

In **Fig.3** ist ein vereinfachtes Ersatzschaltbild zur Ermittlung eines Teilisolationswiderstands Rx eines zu überwachenden Leitungsabschnitts dargestellt.

Der Gesamtisolationswiderstand Riso des ungeerdeten Stromversorgungssystems 2 - betrachtet sei hier nur der maßgebliche ohmsche Anteil des komplexwertigen Isolationswiderstands - umfasst sämtliche zwischen den aktiven Leitern L1, L2 und Erde vorhandenen ohmschen Widerstände RL einschließlich des Isolationsfehlerwiderstands RF und ist aufgrund der Isolationsüberwachung ebenso bekannt wie der bei der Isolationsfehlersuche eingespeiste Prüfstrom IL und der Endwert Ix des erfassten Differenzstroms.

Aus diesen Größen kann der Teilisolationswiderstand Rx des zu überwachenden Leitungsabschnitts berechnet werden:

$$ Rx = Riso \; (IL \; / \; Ix). $$

## Patentansprüche

1. Verfahren zur Isolationsfehlersuche in einem ungeerdeten Stromversorgungssystem (2), umfassend die wiederholt durchzuführenden Verfahrensschritte:

   Erzeugen eines periodischen Prüfstroms (IL) mittels eines Prüfstromgenerators (14), wobei der Prüfstrom (IL) eine vorgegebene maximale Prüfstromamplitude und eine Prüfstromperiode mit einer veränderlichen Prüfstrom-Periodendauer (T) aufweist und die Prüfstromperiode aus zeitlich aufeinanderfolgenden Prüfstromimpulsen und Prüfstrompausen zusammengesetzt wird,
   Einspeisen des Prüfstroms (IL) in das ungeerdete Stromversorgungssystem (2),
   Erfassen eines Differenzstroms in einem zu überwachenden Leitungsabschnitt,
   Bestimmen jeweils eines stationären eingeschwungenen Zustands und eines stationären abgeklungenen Zustands des Differenzstroms und Bestimmen einer zugehörigen Einschwingdauer und Abklingdauer Bestimmen eines Endwertes (Ix) des Differenzstroms in dem jeweiligen stationären Zustand des Differenzstroms,
   Prüfen, ob der Endwert (Ix) des Differenzstroms betragsmäßig einen Prüfstrom-Grenzwert überschreitet, um einen erfassbaren Prüfstrom zu erkennen,
   Übermitteln des Wertes der Einschwingdauer und der Abklingdauer an den Prüfstromgenerator (14),
Einstellen einer Prüfstrom-Impulsdauer (T1, T3) und einer Prüfstrom-Pausendauer (T2, T4) durch den Prüfstromgenerator (14) in Abhängigkeit der übermittelten Einschwingdauer und Abklingdauer so, dass der Differenzstrom seinen Endwert (Ix) innerhalb der Prüfstrom-Impulsdauer (T1, T3) und der Prüfstrom-Pausendauer (T2, T4) erreicht, wobei die vorgegebene maximale Prüfstromamplitude unverändert bleibt, wobei
bei abgeklungenem Prüfstromimpuls ein erster Differenzstrom-Basiswert, von dem aus der folgende Prüfstromimpuls einschwingt, bestimmt wird,
nach Einspeisen des Prüfstromimpulses bei eingeschwungenem Prüfstromimpuls ein Einschwing-Differenzbetrag zwischen dem Differenzstrom-Endwert (Ix) und dem ersten Differenzstrom-Basiswert gebildet wird,
nach Abklingen des Prüfstromimpulses ein zweiter Differenzstrom-Basiswert, auf den der vorangegangene Prüfstromimpuls abgeklungen ist, bestimmt wird,
ein Abkling-Differenzbetrag zwischen dem Differenzstrom-Endwert (Ix) und dem zweiten Differenzstrom-Basiswert gebildet wird,
falls der Einschwing-Differenzbetrag innerhalb eines Toleranzbereichs mit dem Abkling-Differenzbetrag übereinstimmt, eine gültige Erfassung des Differenzstroms vorliegt, um den erfassbaren Prüfstrom zu erkennen.

2. Verfahren nach Anspruch 1,
**dadurch gekennzeichnet,**
**dass** ein Teilisolationswiderstand (Rx) des zu überwachenden Leitungsabschnitts aus einem von einem Isolationsüberwachungsgerät (12) bestimmten Gesamtisolationswiderstand (Riso) des ungeerdeten Stromversorgungssystems (2), aus dem eingespeisten Prüfstrom (IL) und aus dem Endwert (Ix) des Differenzstroms bestimmt wird.

3. Verfahren einem der Ansprüche 1 oder 2,
**dadurch gekennzeichnet,**
**dass** die Prüfstromperiode zeitlich unmittelbar aufeinanderfolgend aus einem positiven Prüfstromimpuls, einer positiven Prüfstrompause, einem negativen Prüfstromimpuls und einer negativen Prüfstrompause gebildet wird.

4. Verfahren nach einem der Ansprüche 1 bis 3,
**dadurch gekennzeichnet,**
**dass** das Erzeugen des Prüfstroms (IL) in dem Prüfstromgenerator (14) aktiv durch eine unabhängige Spannungs- oder Stromquelle innerhalb des Prüfstromgenerators (14) erfolgt.

5. Verfahren nach einem der Ansprüche 1 bis 3,
**dadurch gekennzeichnet,**
**dass** das Erzeugen des Prüfstroms (IL) in dem Prüfstromgenerator (14) passiv erfolgt, wobei der Prüfstrom (IL) durch die Netzspannung zwischen einem aktiven Leiter (L1, L2) des Stromversorgungssystems (2) und Erde getrieben wird.

6. Isolationsfehlersucheinrichtung (10) für ein ungeerdetes Stromversorgungssystem (2) zur Ausführung des Verfahrens nach einem der Ansprüche 1 bis 5,

mit einem Prüfstromgenerator (14) zur Erzeugung und Einspeisung eines periodischen Prüfstroms mit einer Prüfstromperiode, die aus zeitlich aufeinanderfolgenden Prüfstromimpulsen und Prüfstrompausen zusammengesetzt wird,
mit einem Isolationsfehlersuchgerät (18) zur Auswertung von Differenzströmen, welche von an das Isolationsfehlersuchgerät (18) angeschlossenen Messstromwandlern (16) erfasst werden, wobei
das Isolationsfehlersuchgerät (18) eine Berechnungseinheit zur Bestimmung eines stationären eingeschwungenen und abgeklungenen Zustands des Differenzstroms, zur Bestimmung einer zugehörigen Einschwingdauer und Abklingdauer zur Bestimmung eines jeweiligen Endwertes (Ix) des erfassten Differenzstroms und zur Prüfung, ob der Endwert (Ix) des Differenzstroms betragsmäßig einen Prüfstrom-Grenzwert überschreitet, aufweist,
und durch eine Übermittlungseinrichtung (20) zur Übermittlung des Wertes der Einschwingdauer und Abklingdauer an den Prüfstromgenerator (14),
und dadurch, dass der Prüfstromgenerator (14) eine Prüfstrom-Einstelleinrichtung zur Einstellung einer Prüfstrom-Impulsdauer (T1, T3) und einer Prüfstrom-Pausendauer (T2, T4) in Abhängigkeit der übermittelten Einschwingdauer und Abklingdauer aufweist, wobei die vorgegebene maximale Prüfstromamplitude unverändert bleibt, sowie dadurch, dass die Berechnungseinheit ausgelegt ist zur Bestimmung des ersten Differenzstrom-Basiswertes, des Einschwing-Differenzbetrags, des zweiten Differenzstrom-Basiswertes, des Abkling-Differenzbetrags und zur Prüfung, ob der Einschwing-Differenzbetrag innerhalb des Toleranzbereichs mit dem Abkling-Differenzbetrag übereinstimmt.

7. Isolationsfehlersucheinrichtung (10) nach Anspruch 6,
**gekennzeichnet durch**
eine Bestimmungseinrichtung zur Bestimmung eines Teilisolationswiderstands (Rx) des zu überwachenden Leitungsabschnitts aus einem von einem Isolationsüberwachungsgerät (12) bestimmten Gesamtisolationswiderstand (Riso) des ungeerdeten Stromversorgungssystems (2), aus dem eingespeisten Prüfstrom (IL) und aus dem Endwert (Ix) des Differenzstroms.

8. Isolationsfehlersucheinrichtung (10) nach einem der Ansprüche 6 oder 7,
**dadurch gekennzeichnet,**
**dass** die Prüfstrom-Einstelleinrichtung so ausgeführt ist, dass sich die Prüfstromperiode aus Prüfstromimpulsen und Prüfstrompausen zusammensetzt, wobei die Prüfstromperiode zeitlich unmittelbar aufeinanderfolgend aus einem positiven Prüfstromimpuls, einer positiven Prüfstrompause, einem negativen Prüfstromimpuls und einer negativen Prüfstrompause gebildet wird.

9. Isolationsfehlersucheinrichtung (10) nach einem der Ansprüche 6 bis 8,
**dadurch gekennzeichnet,**
**dass** der Prüfstromgenerator (14) als aktives Gerät ausgeführt ist, welches den Prüfstrom (IL) durch eine unabhängige Spannungs- oder Stromquelle erzeugt.

10. Isolationsfehlersucheinrichtung (10) nach einem der Ansprüche 6 bis 8,
**dadurch gekennzeichnet,**
**dass** der Prüfstromgenerator (14) als passives Gerät ausgeführt ist, wobei der Prüfstrom (IL) durch die Netzspannung zwischen einem aktiven Leiter (L1, L2) des Stromversorgungssystem (2) und Erde getrieben wird.

**Claims**

1. A method for insulation fault location in an ungrounded power supply system (2), comprising the method steps to be carried out repeatedly:

   - generating a periodic test current (IL) by means of a test current generator (14), said test current (IL) comprising a predetermined maximum test current amplitude and a test current period having a changeable test current period duration (T) and said test current period being compiled from temporally consecutive test current pulses and test current pauses,
   - feeding the test current (IL) into the ungrounded power supply system (2),
   - capturing a differential current in a cable section to be monitored,- determining a stationary steady state and a stationary decay state of the differential current and determining a respective settling time and decay time,

   - determining a final value (Ix) of the differential current in the corresponding steady state of the differential current,
   - testing whether the final value (Ix) of the differential current exceeds a test current threshold value according to magnitude in order to identify a capturable test current,
   - transmitting the value of the settling time and the decay time to the test current generator (14),
   - setting a test current pulse duration (T1, T3) and a test current pause duration (T2, T4) as a function of the transmitted settling time and decay time using the test current generator (14) such that the differential current reaches its respective final value (Ix) within the test current pulse duration (T1, T3) and the test current pause duration (T2, T4), said predetermined maximum test current amplitude remaining unchanged
   - a first differential current base value from which the following test current pulse becomes settled being determined when the test current pulse has decayed,
   - a settling differential value being formed between the differential current final value (Ix) and the first differential current base value after supplying the test current pulse when the test current pulse has settled,
   - a second differential current base value to which the previous test current pulse has decayed being determined after the test current pulse has decayed,
   - a decay differential value being formed between the differential current final value (Ix) and the second differential current base value,
   - should the settling differential value coincide with the decay differential value within a tolerance range, a valid capture of the differential current is available in order to identify the capturable test current.

2. The method according to claim 1,
**characterized in that**
a partial insulation resistance (Rx) of the conductor section to be monitored is determined from an overall insulation resistance (Ri-so) of the ungrounded power supply system (2) determined by an insulation monitoring device (12), from the supplied test current (IL) and from the final value (Ix) of the differential current.

3. The method according to any one of the claims 1 to 2,
**characterized in that**
the test current period is formed temporally consecutive from a positive test current pulse, a positive test current pause, a negative test current pulse and a negative test current pause.

**4.** The method according to any one of the claims 1 to 3, **characterized in that** the test current (IL) is actively generated in the test current generator (14) via an independent voltage or power source within the test current generator (14).

**5.** The method according to any one of the claims 1 to 3, **characterized in that** the test current (IL) is passively generated in the test current generator (14), said test current (IL) being driven via the supply voltage between an active conductor (L1, L2) of the power supply system (2) and ground.

**6.** An insulation fault location system (10) for an ungrounded power supply system (2) for executing the method according to any one of the claims 1 to 5,

having a test current generator (14) for generating and supplying a periodic test current having a test current pulse which is compiled of temporally consecutive test current pulses and test current pauses,
having an insulation fault location device (18) for evaluating differential currents which are captured by measuring current transformers (16) connected to the insulation fault location device (18), the insulation fault location device (18) comprising a computing unit for determining a stationary steady and decay state of the differential current, for determining a respective settling time and decay time, for determining a respective final value (Ix) of the captured differential current and for testing whether the final value (Ix) of the differential current exceeds a test current threshold value according to value, and by a transmitting device (20) for transmitting the value of the settling time and decay time to the test current generator (14), and the test current generator (14) comprising a test current setting device for setting a test current pulse duration (T1, T3) and test current pause duration (T2, T4) as a function of the transmitted settling time and decay time, the predetermined maximum test current amplitude remaining unchanged, and the computing unit being configured for determining the first differential current base value, the settling differential value, the second differential base value, the decay differential value, and for testing whether the settling differential value coincides with the decay differential value within a tolerance range.

**7.** The insulation fault location system (10) according to claim 6, **characterized by** a determining device for determining a partial insulation resistance (Rx) of the conductor section to be monitored from an overall insulation resistance (Riso) of the ungrounded power supply system (2) determined by an insulation monitoring device (12), from the supplied test current (IL) and from the final value (Ix) of the differential current.

**8.** The insulation fault location system (10) according to one of the claims 6 or 7, **characterized in that** the test current setting device is carried out such that the test current period is compiled from test current pulses and test current pauses, said test current period being formed temporally consecutively from a positive test current pulse, a positive test current pause, a negative test current pulse and a negative test current pause.

**9.** The insulation fault location system (10) according to one of the claims 6 to 8, **characterized in that** the test current generator (14) is designed as an active device which generates the test current (IL) via an independent voltage or power source.

**10.** The insulation fault location system (10) according to any one of the claims 6 to 8, **characterized in that** the test current generator (14) is designed as a passive device, the test current (IL) being driven through the supply voltage between an active conductor (L1, L2) of the power supply system (2) and ground.

**Revendications**

**1.** Procédé pour la localisation d'un défaut d'isolement dans un système d'alimentation (2) non mis à la terre, le procédé comprenant les étapes à être exécutées à plusieurs reprises :

- générer un courant de test (IL) périodique au moyen d'un générateur (14) de courant de test, ledit courant de test (IL) comprenant une amplitude de courant de test prédéterminée maximale et une période de courant de test ayant une période (T) de courant de test changeable et ladite période de courant de test se composant des impulsions de courant de test et des pauses de courant de test temporellement consécutives,
- alimenter le système d'alimentation (2) non mis à la terre en courant de test (IL),
- enregistrer un courant différentiel résiduel dans une section de câble à être surveillée
- déterminer un état d'établissement stationnaire et un état de déclin stationnaire du courant différentiel résiduel et déterminer une durée d'établissement et une durée de déclin respectives,

- déterminer une valeur finale (Ix) du courant différentiel résiduel dans l'état stationnaire correspondant du courant différentiel résiduel,
- tester si la valeur finale (Ix) du courant différentiel résiduel dépasse un seuil de courant de test en valeur afin d'identifier un courant de test enregistrable,
- transmettre la valeur de la durée d'établissement et de la durée de déclin au générateur (14) de courant de test,
- ajuster une durée (T1, T3) d'impulsion du courant de test et une durée (T2, T4) de pause du courant de test en utilisant le générateur (14) de courant de test en fonction de la durée d'établissement et de la durée de déclin transmises de telle manière le courant différentiel résiduel atteint sa valeur finale (Ix) respective dans la durée (T1, T3) d'impulsion du courant de test et la durée (T2, T4) de pauses du courant de test, ladite amplitude de courant de test prédéterminée maximale restant inchangée,
- une première valeur de base du courant différentiel résiduel à partir de laquelle l'impulsion de courant de test suivante devient établie étant déterminée quand l'impulsion de courant de test est déclinée,
- une valeur différentielle en régime établi étant formée entre la valeur finale (Ix) du courant différentiel résiduel et la première valeur de base du courant différentiel résiduel après que l'impulsion de impulsion de courant de test a été alimentée quand le impulsion de courant de test est en régime établi,
- une deuxième valeur de base du courant différentiel résiduel sur laquelle l'impulsion de courant de test précédente a décliné étant déterminée après que l'impulsion de courant de test est déclinée,
- une valeur différentielle de déclin étant formée entre la valeur finale (Ix) du courant différentiel résiduel et la deuxième valeur de base du courant différentiel résiduel,
- si la valeur différentielle en régime établi coïncide avec la valeur différentielle en régime décliné dans une plage de tolérance, un enregistrement valide du courant différentiel résiduel est disponible pour identifier le courant de test capturable.

2. Procédé selon la revendication 1,
   **caractérisé en ce**
   **qu'**une résistance d'isolement partiel (Rx) de la section conductrice à être surveillée est déterminée à partir d'une résistance d'isolement totale (Ri-so) du système d'alimentation (2) non mis à la terre déterminée par un contrôleur d'isolement (12), à partir du courant de test (IL) alimenté et à partir de la valeur finale (Ix) du courant différentiel résiduel.

3. Procédé selon l'une quelconque des revendications 1 à 2,
   **caractérisé en ce que**
   la période de courant de test est formée de manière consécutive temporellement à partir d'une impulsion de courant de test positive, à partir d'une pause de courant de test positive, à partir d'une impulsion de courant de test négative et à partir d'une pause de courant de test négative.

4. Procédé selon l'une quelconque des revendications 1 à 3,
   **caractérisé en ce que**
   le courant de test (IL) est généré activement dans le générateur (14) de courant de test par une source de tension ou de courant indépendante dans le générateur (14) de courant de test.

5. Procédé selon l'une quelconque des revendications 1 à 3,
   **caractérisé en ce que**
   le courant de test (IL) est généré passivement dans le générateur (14) de courant de test, ledit courant de test (IL) étant entraîné par la tension d'alimentation entre un conducteur actif (L1, L2) du système d'alimentation (2) et la terre.

6. Système (10) de localisation d'un défaut d'isolement pour un système d'alimentation (2) non mis à la terre pour exécuter le procédé selon l'une quelconque des revendications 1 à 5, ayant un générateur (14) de courant de test pour générer et alimenter en un courant de test périodique ayant une période de courant de test qui se compose des impulsions de courant de test et des pauses de courant de test temporellement consécutives,

   ayant un dispositif (18) de localisation d'un défaut d'isolement pour évaluer des courants différentiels résiduels qui sont enregistrés au moyen des transformateurs (16) de courant pour mesures reliés au dispositif (18) de localisation d'un défaut d'isolement,
   le dispositif (18) de localisation d'un défaut d'isolement comprenant une unité d'informatique pour déterminer un état d'établissement stationnaire et un état de déclin stationnaire du courant différentiel résiduel, pour déterminer une durée d'établissement et une durée de déclin respectives, pour déterminer une valeur finale (Ix) respective du courant différentiel résiduel enregistré et pour tester si la valeur finale (Ix) du courant différentiel résiduel dépasse un seuil de courant de test en valeur, et par un dispositif de transmission (20) pour transmettre la valeur de la durée d'établissement et de la durée de déclin au générateur (14) de courant de test,
et le générateur (14) de courant de test comprenant un dispositif d'ajustage pour le courant de test pour ajuster une durée (T1, T3) d'impulsion de courant de test et une durée (T2, T4) de pause de courant de test en fonction de la durée d'établissement et de la durée de déclin transmises, ladite amplitude de courant de test prédéterminée maximale restant inchangée, et l'unité d'informatique étant configurée pour déterminer la première valeur de base du courant différentiel résiduel, de la valeur différentielle en régime établi, la deuxième valeur de base différentielle, la valeur différentielle en régime décliné, et pour tester si la valeur différentielle en régime établi coïncide avec la valeur différentielle en régime décliné dans la plage de tolérance.

7. Système (10) de localisation d'un défaut d'isolement selon la revendication 6,
**caractérisé par**
un dispositif de détermination pour déterminer une résistance d'isolement partiel (Rx) d'une section de conducteur à être surveillée à partir d'une résistance d'isolement totale (Ri-so) du système d'alimentation (2) non mis à la terre déterminée par un contrôleur d'isolement (12), à partir du courant de test (IL) alimenté et à partir de la valeur finale (Ix) du courant différentiel résiduel.

8. Système (10) de localisation d'un défaut d'isolement selon la revendication 6 ou la revendication 7,
**caractérisé en ce que**
le dispositif d'ajustage du courant de test est exécuté de telle manière que la période de courant de test se compose des impulsions de courant de test et des pauses de courant de test, ladite période de courant de test étant formée de manière temporellement consécutive à partir d'une impulsion de courant de test positive, à partir d'une pause de courant de test positive, à partir d'une impulsion de courant de test négative et d'une pause de courant de test négative.

9. Système (10) de localisation d'un défaut d'isolement selon l'une quelconque des revendications 6 à 8,
**caractérisé en ce que**
le générateur (14) de courant de test est conçu comme dispositif actif qui génère le courant de test (IL) par une source de tension ou de courant indépendante.

10. Système (10) de localisation d'un défaut d'isolement selon l'une quelconque des revendications 6 à 8,
**caractérisé en ce que**
le générateur (14) de courant de test est conçu comme dispositif passif, le courant de test (IL) étant entrainé par la tension d'alimentation entre un conducteur actif (L1, L2) du système d'alimentation (2) et la terre.

**Fig. 1**

EP 3 413 062 B1

**Fig. 2**

**Fig. 3**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 3139188 A1
- EP 1593983 A1